# EUROPEAN PATENT SPECIFICATION

(11) **EP 3 189 338 B1**
(45) Date of publication and mention of the grant of the patent: **13.03.2024**
(21) Application number: 15766309.7
(22) Date of filing: 03.09.2015
(51) Int. Cl.: G01R 19/155, G01R 31/327

(54) **METHOD AND DEVICE FOR DETECTING THE ABSENCE OF VOLTAGE**
VERFAHREN UND VORRICHTUNG ZUR ERFASSUNG DER ABWESENHEIT VON SPANNUNG
PROCÉDÉ ET DISPOSITIF POUR DÉTECTER DE L'ABSENCE DE TENSION

(30) Priority: 05.09.2014 US 201462046419 P
(43) Date of publication of application: 12.07.2017
(73) Proprietor: Panduit Corp., Tinley Park, IL 60487 (US)
(72) Inventor: BUGARIS, Rachel M., Lexington, Kentucky 40509 (US); HOEPPNER, Craig T., Bolingbrook, Illinois 60440 (US); SENESE, John C., Naperville, Illinois 60565 (US)
(74) Representative: Harden, Henry Simon
(86) International application number: PCT/US2015/048348
(87) International publication number: WO 2016/036952

(56) References cited:
- WO-A1-2012/084102
- WO-A2-2005/029101
- US-A1- 2005 237 048
- US-A1- 2008 081 516
- US-A1- 2010 033 190
- US-A1- 2013 214 922

## Description

### Field of Invention

This application relates to electrical safety and describes a system and method for determining the absence of voltage with a permanently installed voltage tester in electrical equipment.

### Background

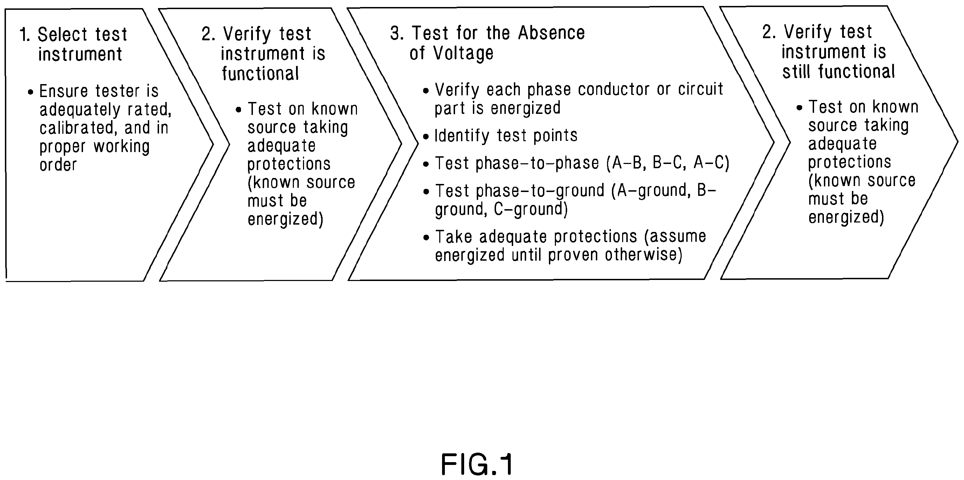

Traditionally, portable test instruments are used to verify the absence of voltage. Voltage verification with a portable test instrument is a multi-step process as shown in Figure 1. Some of the steps in the process are time consuming, complex with many sub-steps, and involve exposure to electrical hazards.

Although the voltage verification process with a portable test instrument is considered best practice, it is not without limitations. Portable instruments are susceptible to mechanical and electrical failure, as well as misuse by the person using the portable device. Throughout the entire process, the person performing the voltage verification test is exposed to potential electrical hazards that could result in injuries or death. To ensure safety, all conductors are presumed to be energized until proven otherwise, which requires the use of additional precautions, such as personal protective equipment (PPE). Furthermore, if the process is not performed, or performed in an abbreviated fashion, the likelihood of an incident resulting in injury is even greater. Because the process is highly dependent on human input, interaction, and interpretation, it is susceptible to mistakes and errors.

In order to improve worker safety and the efficiency of the process, it is desirable to be able to determine whether electrical hazards are present before accessing electrical equipment. If voltage is not present, the risk of electrical shock, arc flash, and arc blast are eliminated.

The use of voltage indicators is becoming more common in industrial applications due to increased awareness of the need for electrical safety. These devices are effective at providing a warning when voltage is present, but they are not reliable for absence of voltage verification. Typically, voltage indicators are hardwired into the three-phase circuit and are powered only by the circuit they are monitoring. Thus, they are only able to indicate the presence of voltage. In order to verify the absence of voltage, the process with a portable test instrument is still required because voltage indicators do not have a way to determine if the lack of signal is from a faulty device, a lost connection, or a truly de-energized condition.

Injecting a test current into the device has been proposed in US 8,013,613, so that the device could momentarily be transitioned to energized to verify the functionality of the indicators. Although this is an improvement and verifies that the indicator is functioning, it does not verify that the hardwired connection between the voltage indicator and the circuit being monitored is intact and does not directly signal the absence of voltage. Thus, a more robust method is needed to test for and verify the absence of voltage with a permanently installed device.
US2010/0033190A1 discloses an electrical test device including at least one transducer to detect a status of a circuit under test, and at least one indicator located remotely from the at least one transducer to display the status of the circuit under test.
US2013/0214922A1 discloses an electrical safety monitor for monitoring electrical energy potentials of one or more electrical power input lines of an AC circuit.
WO2005/029101A2 discloses a system operable to detect voltages within an electrical device and provide an output based on the voltages detected by the system.
US2005237048 A1 discloses an operability testing apparatus used in conjunction with an electrical testing apparatus to perform live-dead-live tests.

### Summary of the Invention

The invention provides an installed device electrically connected to a power source according to claim 1 as well as a method for testing for absence of voltage according to claim 7.

The installed device has circuitry capable of detecting voltage, performing self-diagnostics, and testing for connectivity to the power source. In one embodiment, the device can also check to see if the voltage is at a de-energized level, recheck for continuity and repeat the self-diagnostics. In another embodiment, the installed device can be electrically connected to the line and load side of a disconnect and have circuitry configured to check the status of the disconnect. In another embodiment, the device can be configured to communicate with a portable reader in order to transfer information to the portable reader. In yet another embodiment, the device can be configured to interact with a controller that controls access to the panel in which the device is installed.

### Brief Description of the Drawings

Figure 1 is a flow chart showing a prior art method of voltage verification using a portable test instrument.
Figure 2 is a flowchart showing a method to verify the absence of voltage using an installed testing device.
Figure 3 is a flowchart showing a method of verifying the absence of a signal with an installed device further incorporating presence and absence indicators.
Figure 4 is a flowchart showing a method combining positive absence and presence of voltage indications with the verification of voltage using the installed testing device.
Figure 5 is a diagram of components used a in a system designed to perform the method of Figure 4.
Figure 6 shows a system with a testing device attached to both a load and line of an electrical disconnect.
Figure 7 shows a system with a single testing device attached to both the load and line side of an electrical disconnect.
Figure 8 is a flowchart showing a method of verifying the absence of voltage with a device installed on both the load and line of a disconnect.

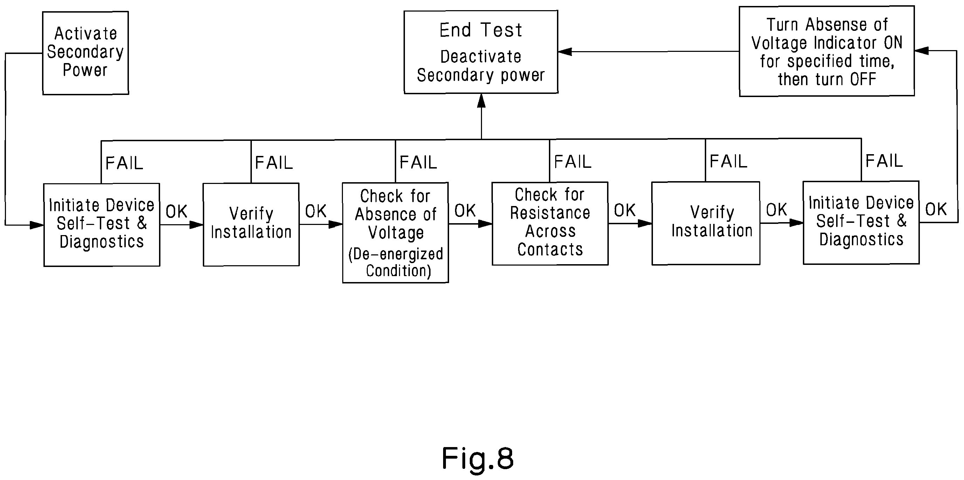

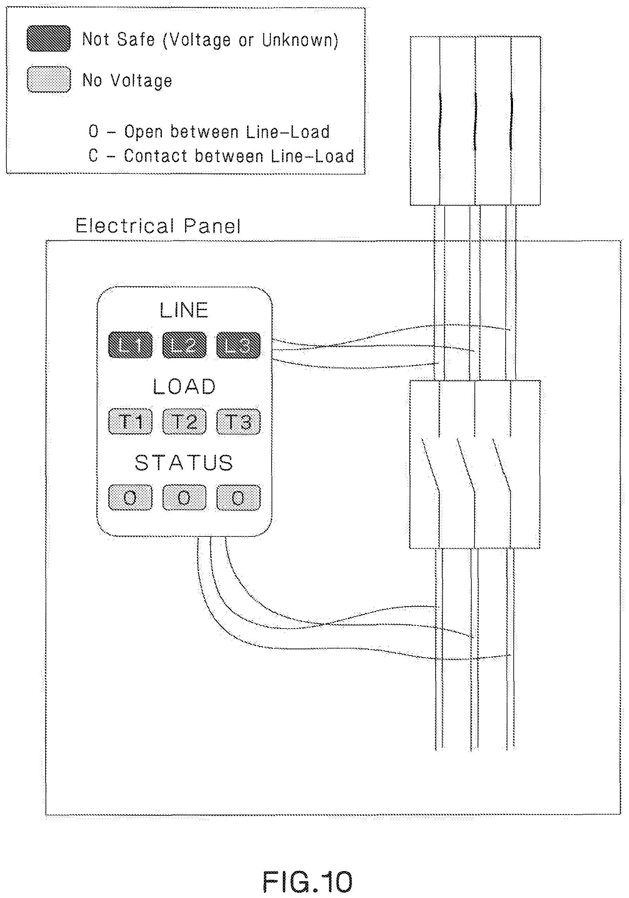

Figure 8 shows testing results of having separate devices on the line and load side with power on the line side of the disconnect and the disconnect open while Figure 10 shows the same with a single device connected to both the line and load side of the disconnect.

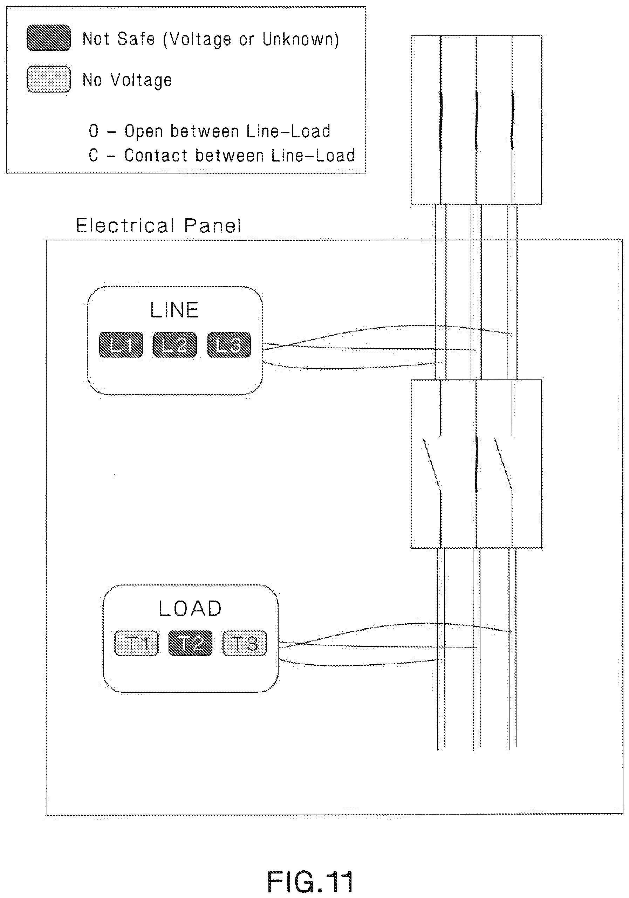

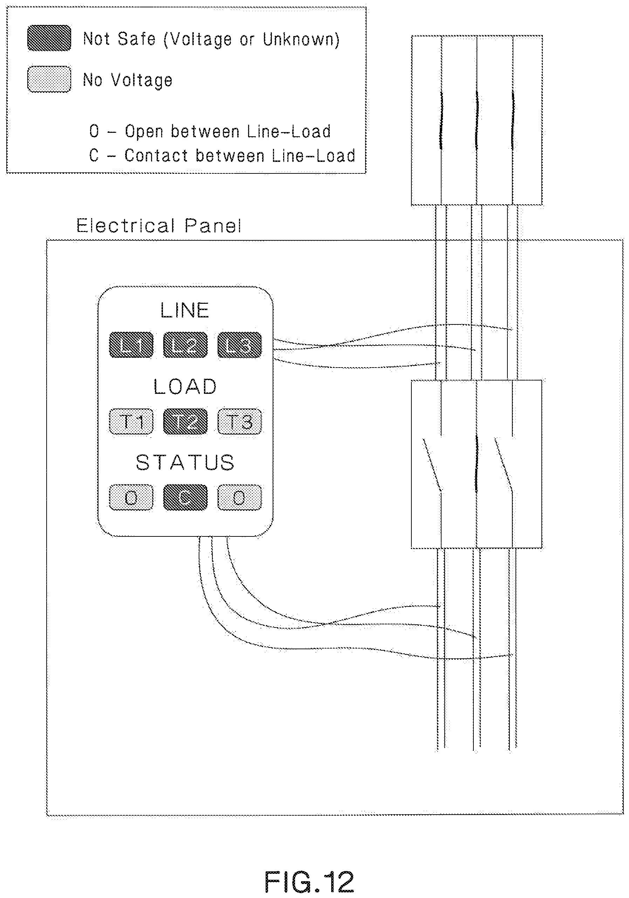

Figure 11 shows testing results of having separate devices on the line and load side with power on the line side of the disconnect and the disconnect open with a problem on phase 2 while Figure 12 shows the same with a single device connected to both the line and load side of the disconnect.

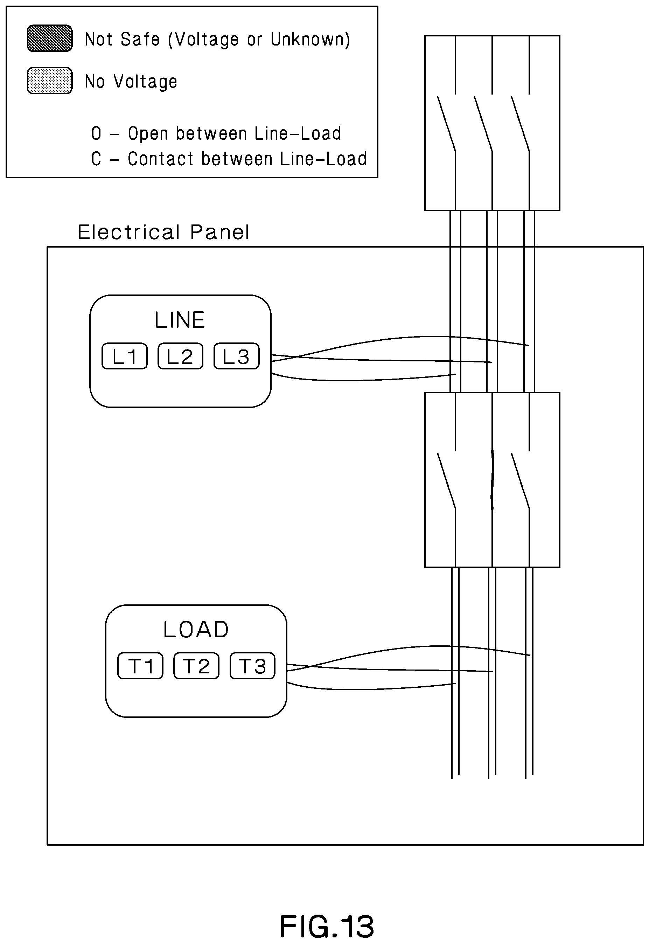

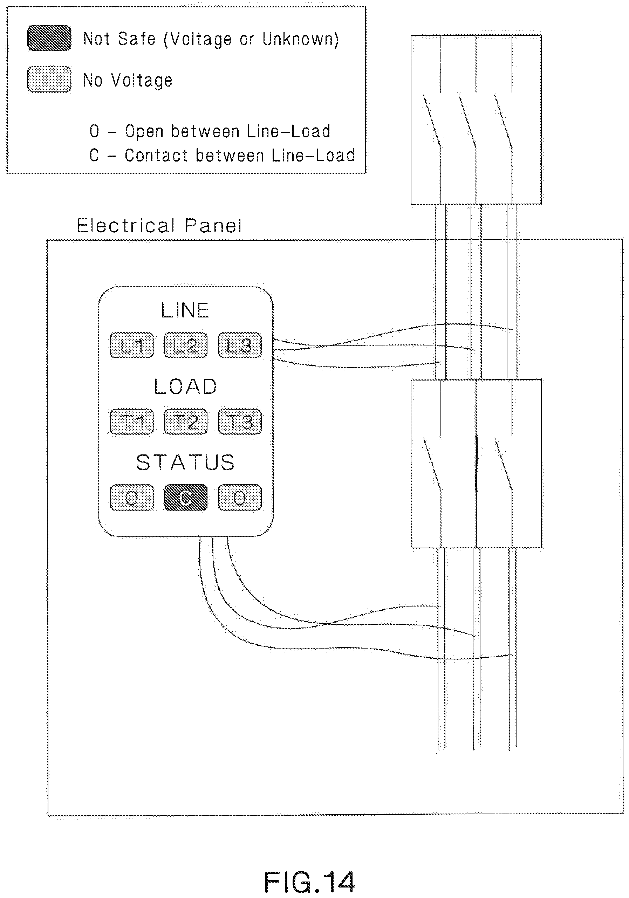

Figure 13 shows testing results of having separate devices on the line and load side with no power on the line side of the disconnect and the disconnect open with a problem on phase 2 while Figure 14 shows the same with a single device connected to both the line and load side of the disconnect.

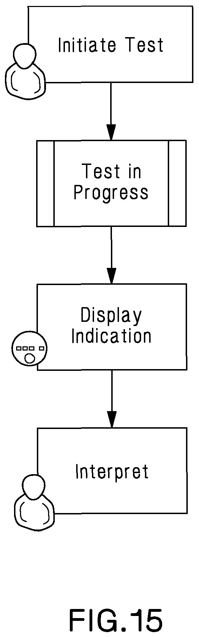

Figure 15 is a flow chart showing the basic sequence of a testing device used to indicate the absence of voltage.

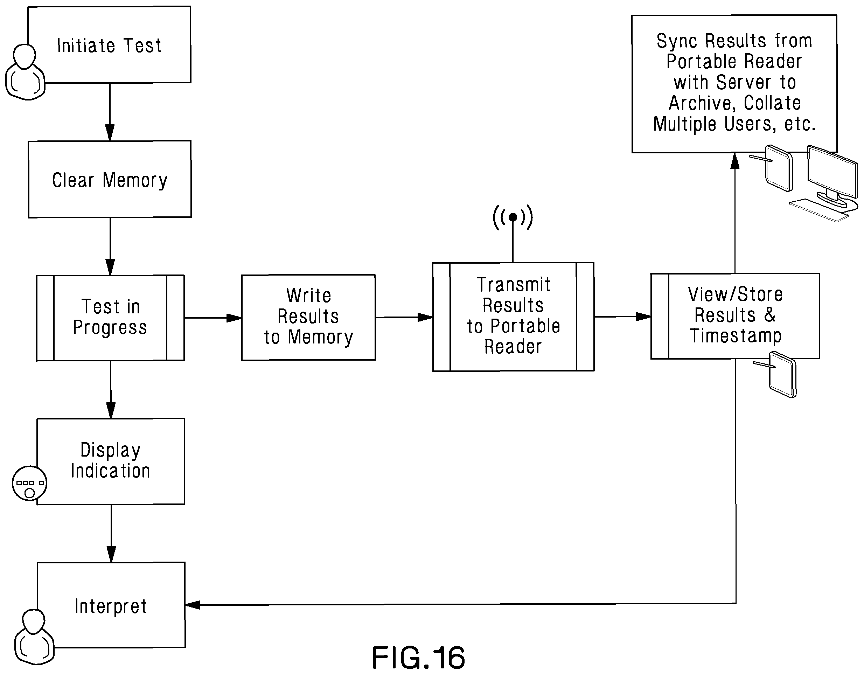

Figure 16 is a flow chart showing how the sequence of Figure 11 can be modified to include a step to write intermediate results to internal memory.

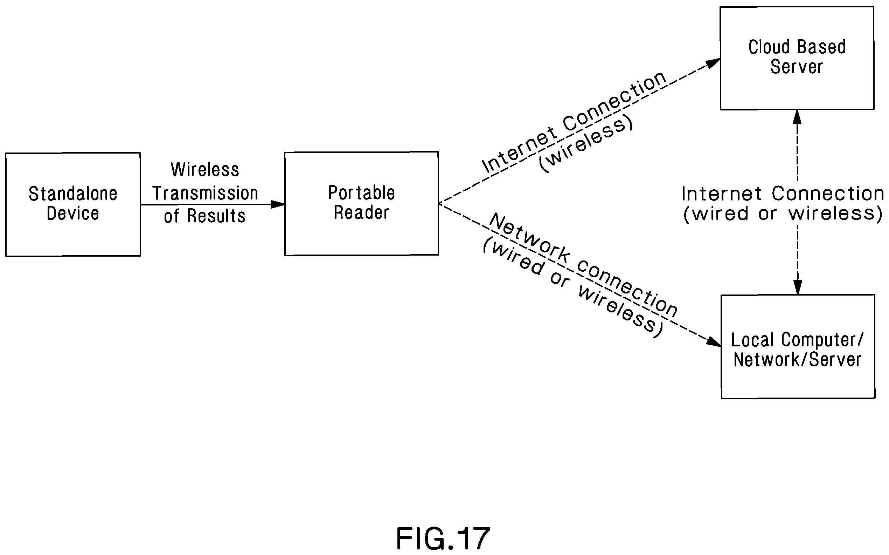

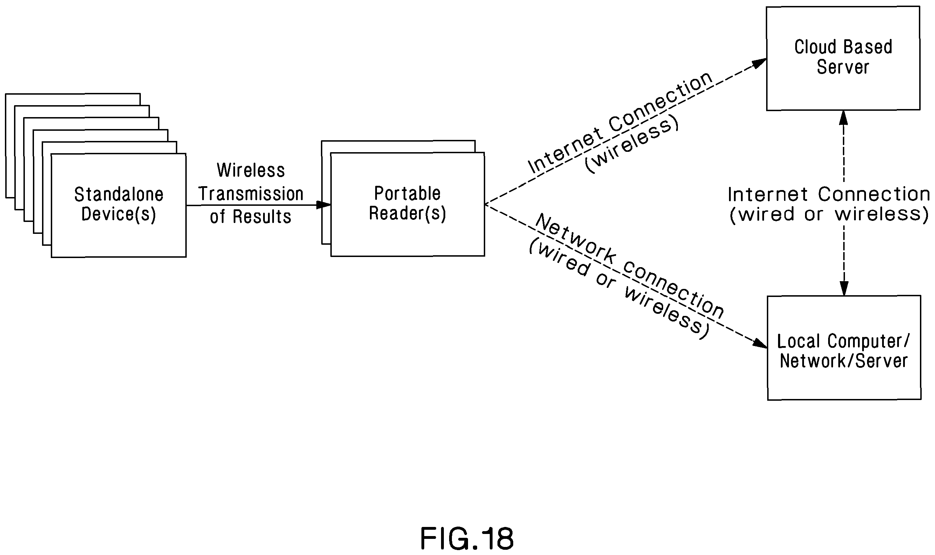

Figures 17 and 18 is a flow chart showing how the information from testing devices can be transferred between devices through various connections.

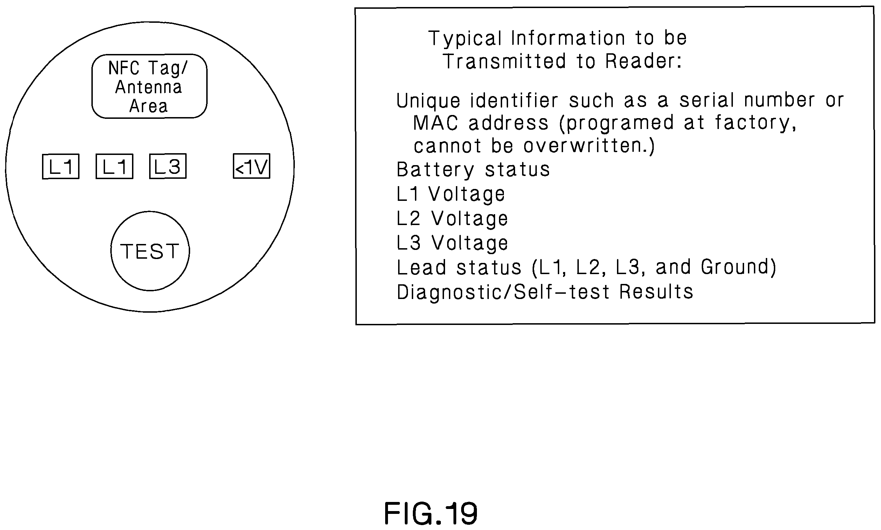

Figure 19 shows one embodiment of a front display of a testing device.

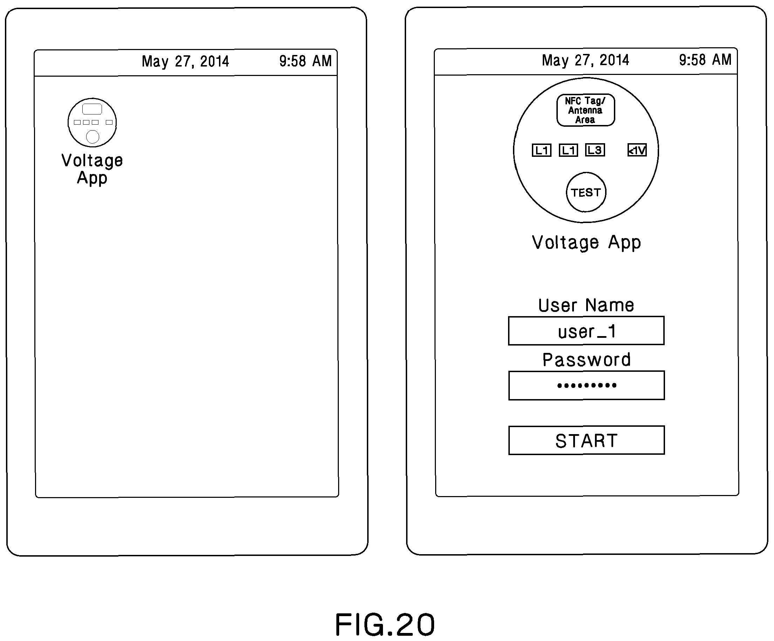

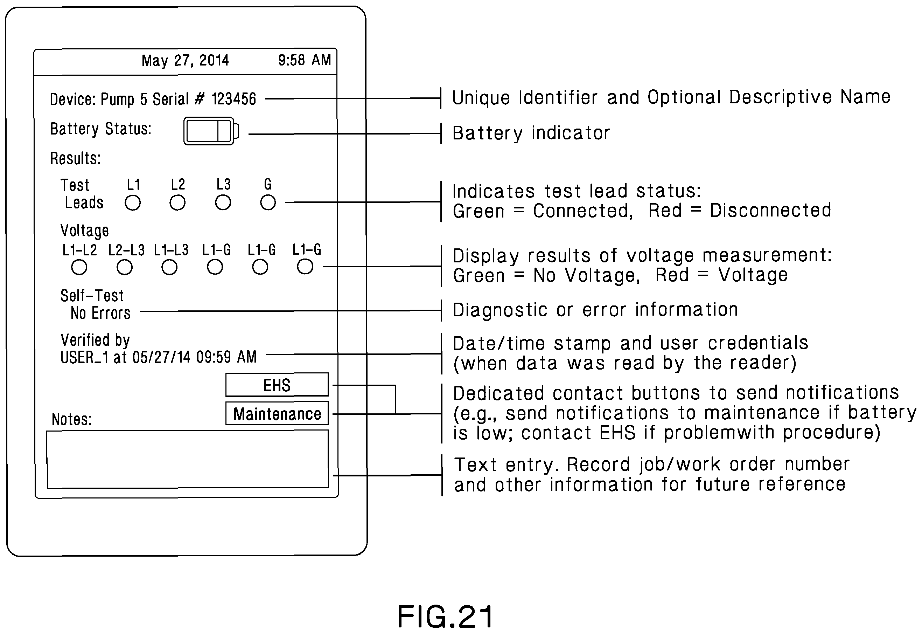

Figures 20 and 21 show displays from a portable reader using an application to communicate with the testing device.

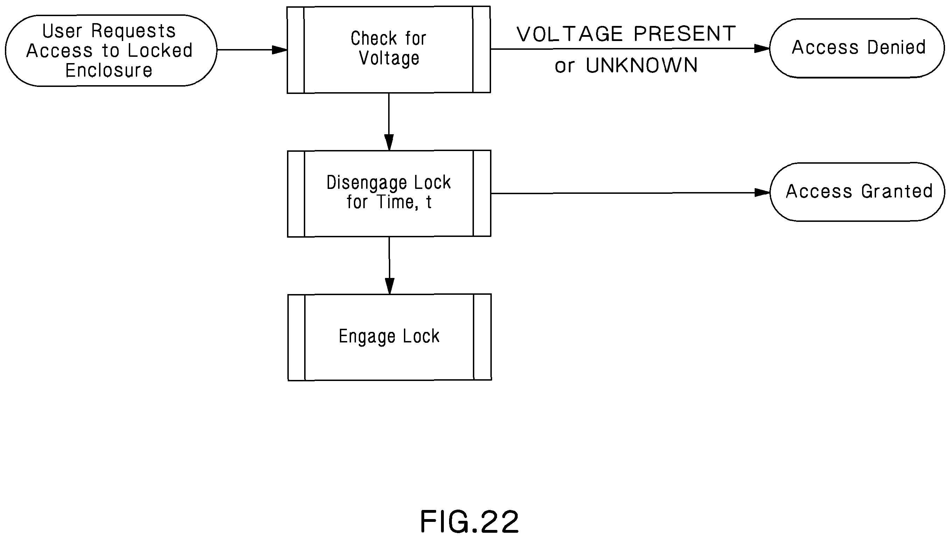

Figure 22 is a flow chart showing the basic process of using a testing device to control access to an enclosure.

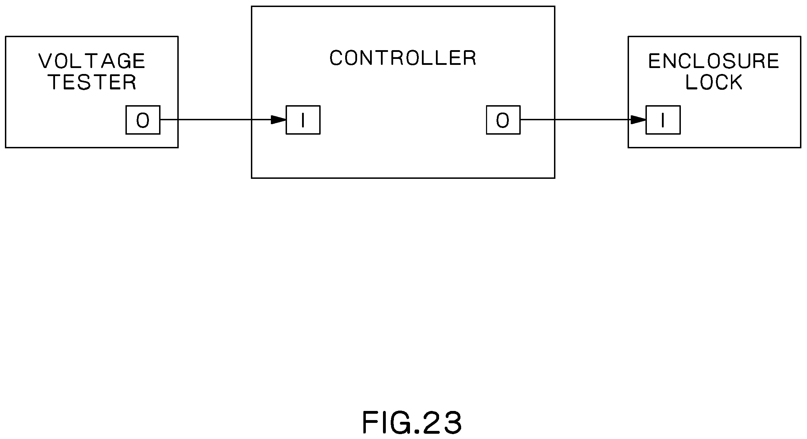

Figure 23 shows the basic components and input and output relationship of a system for implementing the method of Figure 22.
Figure 23 is a flow chart showing the basic process of using a testing device to control access to an enclosure with credential authentication.

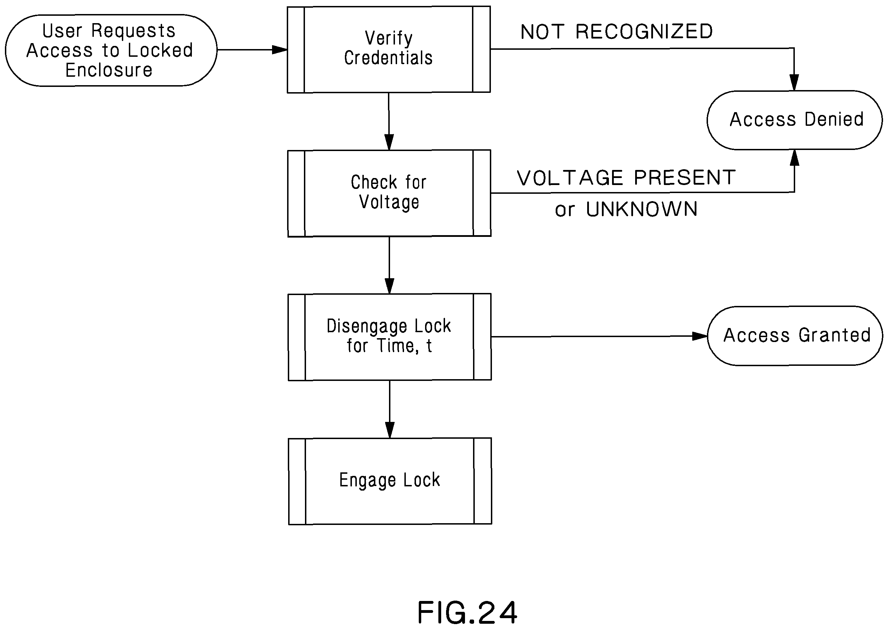

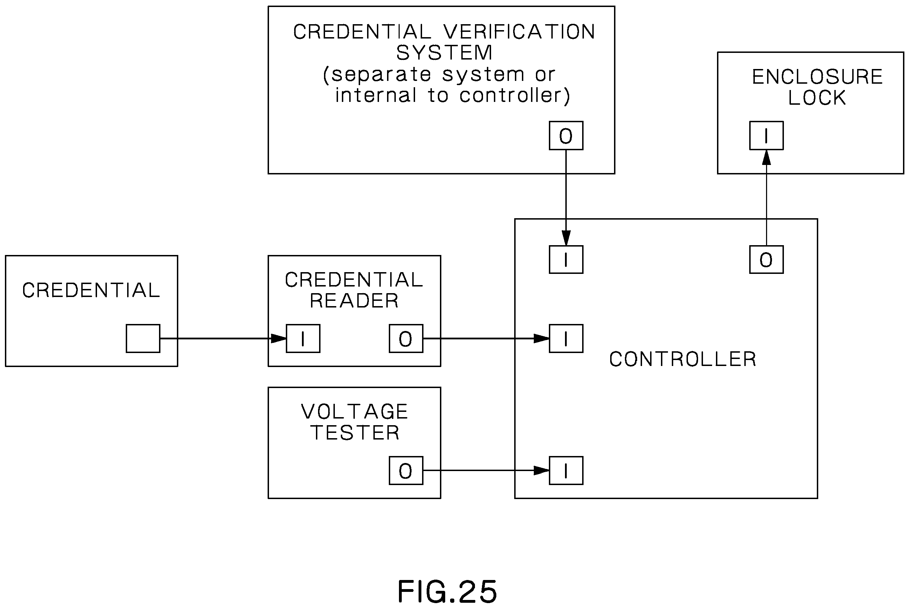

Figure 24 shows the basic components and input and output relationships of a system for implementing the method of Figure 13.

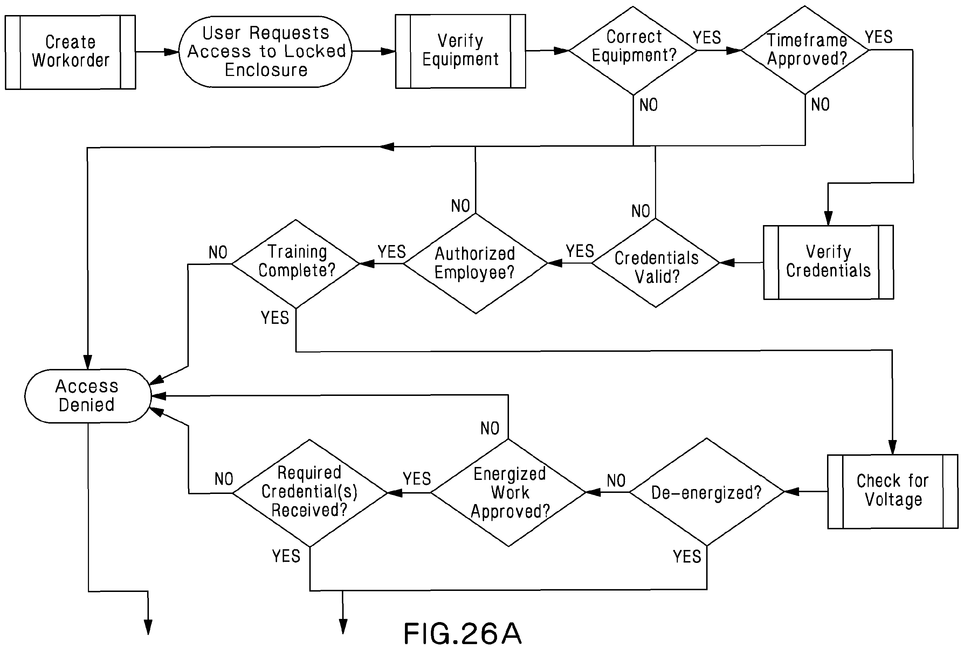

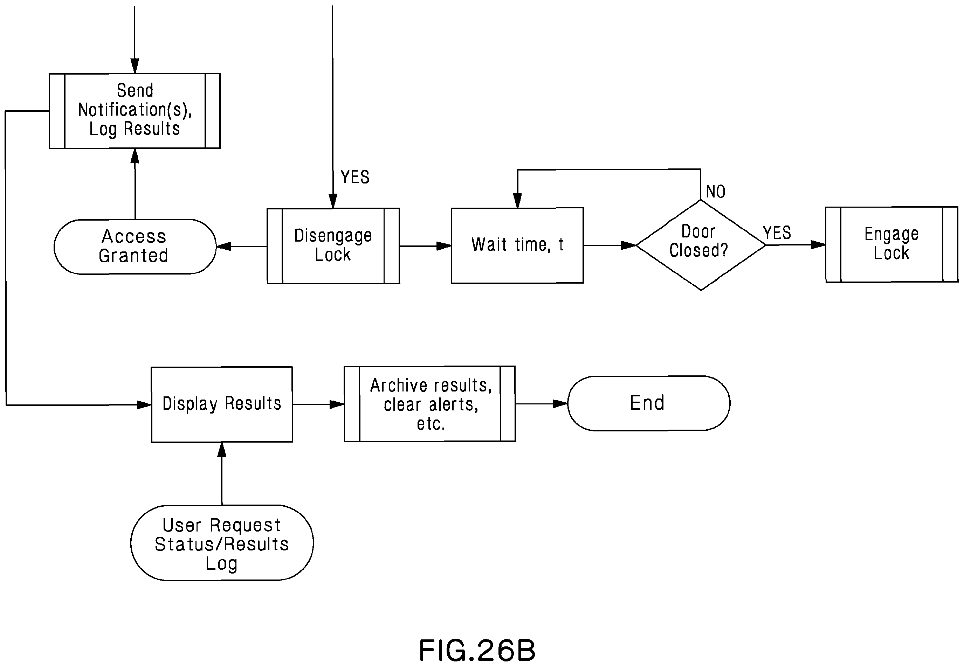

Figures 26A and 26B is a flow chart showing an advanced process of using a testing device to control access to and enclosure.

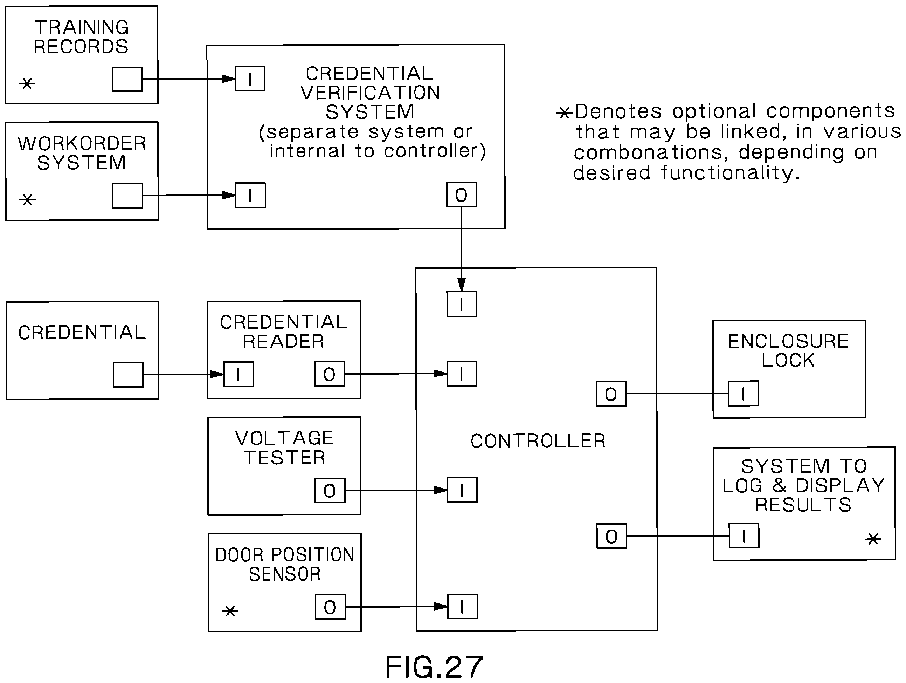

Figure 27 shows the basic components and input and output relationship of a system for implementing the method of Figures 26A and 26B.

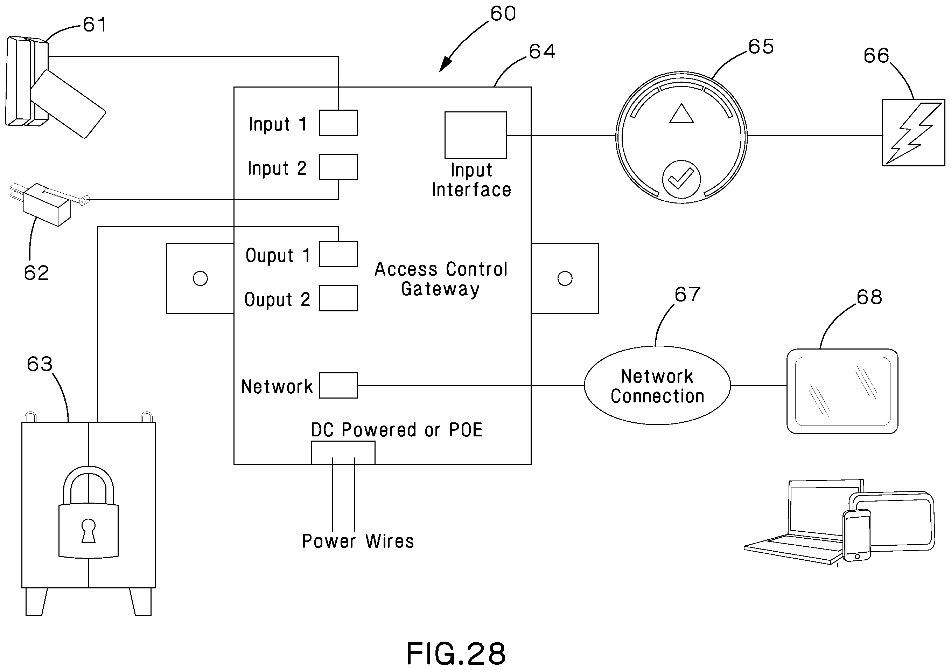

Figure 28 shows elements to be used in a system to control access to energized electrical equipment.

### Detailed Description of the Invention

In order to verify the absence of voltage, the user must be able to discern that conductors are de-energized, the test instrument used to determine that the conductors are de-energized is functional before and after use, and that the part of the circuit intended to be measured was in fact tested. Furthermore, to eliminate possible exposure of a person to electrical hazards, it is desirable to be able to make this determination without accessing the equipment. Accomplishing reliable verification before accessing electrical equipment while the door or cover is still in place greatly enhances safety in several ways. It prevents the person interacting with the equipment from inadvertently making contact with an unintended part of the circuit or shorting conductors if the equipment is in fact energized. It also increases the distance between the person and the potentially energized conductive parts as well as possibly containing any resulting effects should an arc flash occur.

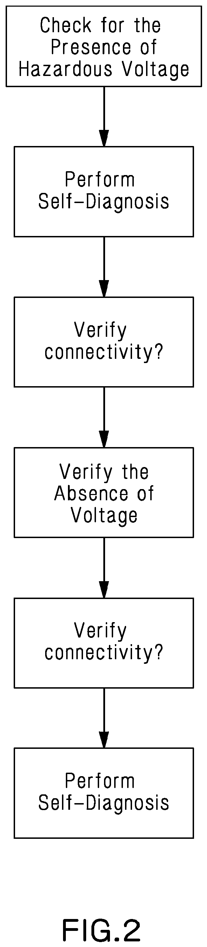

The method shown in Figure 2 can be used to verify the absence of voltage in an electrical enclosure with an installed testing device hardwired (or otherwise directly connected) to the point of the circuit desired to test without accessing the equipment, thereby preventing exposure to circuit conductors until they have been proven to be de-energized. This method can be triggered by the lack of signal from a voltage presence indicator (step 0) or independently (beginning at step 1).

Checking for the presence of voltage (step 0) leverages existing voltage indicator technology. If voltage above about approximately 30-50V, for example, is detected, an indicator will activate, typically by illuminating one or more LEDs. This indicator serves as a warning that hazardous voltage is present. If the voltage presence indicator is not active, further investigation is required to determine and prove that voltage is absent. This is where the added functionality of using an installed testing device in order to verify the absence of voltage begins (although depending on techniques used to perform the remaining steps, it may be desirable to not initiate the process unless hazardous voltage is not present in order to protect the electronics of the installed testing device and the system that is being monitored). The first step (step 1) is to test the installed testing device by performing a series of self-diagnostics and/or internal checks to verify that it is indeed working and has not failed. This requires a secondary power source that is independent of the primary power source of the circuit being monitored. If the device is functioning, it is then important to verify that connectivity exists between the installed testing device and the circuit part that is intended to be monitored (step 2). This step is critical and is required to confirm that if no voltage is detected in step 3, it is because there is in fact no voltage on the circuit, and not due to an installation failure that would leave the lead of the installed testing device uncoupled from the voltage source, thus preventing false indications of the absence of voltage. Next, the absence of voltage must be verified through a detection method. A de-energized condition must be observed (step 3) (when verifying the absence of a signal, such as voltage, it is important to ensure that the signal is truly absent down to a de-energized level (~0V), not just a non-hazardous voltage (< ~30V). Then the connectivity must again be verified (step 4) to ensure that if a de-energized condition exists, it is because there is in fact ~0V on the line and is not due to an installation failure or lack of connectivity between the installed testing device and the circuit being monitored. Finally, the installed testing device must repeat self-diagnostics (step 5) to ensure it is still functional. If the criteria for each step in the process are satisfied, it can then be concluded that the absence of voltage has been verified. The sequence of steps is important to the reliability of the method and end result so a processor can be used to ensure that these steps are performed automatically and in correct order.

Some of the key elements required in an installed system that utilizes this method and device include the combination of the following: an installed (not portable) testing device/instrument directly connected (e.g., hardwired) to the circuit being monitored, a reliable approach to conduct self-diagnostics, a connectivity test (to verify the integrity of the direct connection between the installed testing device and circuit being monitored, voltage detection technique that covers the complete range of possible voltages the equipment may experience, an ability to provide a positive indication of the absence of voltage (and optionally voltage presence), a secondary power source and infrastructure to power the installed testing device when the circuit being monitored is de-energized, and a way of ensuring the method is executed in proper sequence with output based on logic discerned from observed or measured conditions in each step. The significance of each of these elements or feature and the value they provide to the overall method is described below.

**Permanently installed device/system.** The voltage test and verification method described herein has several advantages over the conventional method that utilizes a portable tester.
∘ An installed system that includes verification of connectivity and testing device functionality can be initiated from outside the panel without accessing the panel. This keeps personnel from being directly exposed to electrical hazards during the voltage verification process. A closed panel cover or door increases the distance and acts as a barrier between the person and the hazard - two factors that reduce the likelihood and severity of electrical injury.
∘ Installed systems are typically hardwired in and make direct contact with circuit parts. When using a portable test instrument, the user must identify the correct circuit parts and make contact with uninsulated areas. If the portable test instrument probes are not in full contact with the conductors or are inadvertently placed over insulation, false readings can occur.
∘ Assuming installation is done properly with correct device for the application, the installed testing device will be suitable for the application. Incidents have occurred due to use of incorrect test instruments based on incompatible ratings between the test instrument and circuit/equipment. Additionally, some test instruments have multiple settings that must be selected based on the application and intended function. A permanently installed system selected for the specific equipment desired to be tested and confirmed whenever any modifications are made to the equipment ensures that errors will not occur due to the use of a voltage test instrument that was not suited for the application.
∘ Portable instruments are susceptible to mechanical and electrical damage. The installed testing device is much less likely to be subjected to physical abuse (when adequately rated for the application) and can be designed to detect internal failures and fail in a safe mode. Portable test instruments may have or develop loose connections, poor contact, damaged probes, etc. when transported between equipment or used in improper applications over the course of its life.

**Connectivity verification.** This is an important step and one missing from current state-of-the art. In order to rely on an absence of voltage indication from a non-portable system, it is important to confirm that the installed testing deevice is still directly coupled as intended with direct connection to the circuit part desired to be monitored. Additionally, it is advantageous to accomplish this verification without the need to directly access the equipment (i.e., keeping the doors and covers closed), which often results in no direct line of sight. In industrial electrical equipment, installation failure is typically a loose or severed connection due to a faulty termination, thermal expansion, or vibration. When verifying the *absence* of a signal, such as voltage, this can be accomplished by verifying that there is continuity throughout the system or device from the indicator to the main circuit. There are several techniques that can be used to verify that connectivity exists between the leads of the test device and the circuit conductors, thus ensuring that the device installation is intact.

**Positive indication of absence.** Typical indicators convey the presence of a signal by illuminating an LED or some other type of active indication (digital display, audio, etc.). These indicators have no means of directly communicating the absence of a signal, and default to simply allowing the person interacting with the indicator to assume that the signal is absent when there is lack of illumination of the same indicator. When conveying status that is directly related to safety, this can be a dangerous assumption. Therefore, the method described in this RS utilizes an active indicator to convey the absence of voltage. Providing positive indications is one way in which this method seeks to ensure that all indications result in a fail-safe condition.

**Secondary power source.** In order to provide an active indication of the absence of a signal (as well as to power any microprocessors and electronics that are utilized to perform the steps described in this method), a secondary power source that is separately derived and independent from the circuit being monitored is required. It is also essential that this secondary power source operate at a non-hazardous voltage. The secondary power can be provided from a variety of sources depending on the application and what type of power infrastructure is readily available. Secondary power can be provided on a temporary or continuous basis or some combination.
∘ Examples of temporary sources may include storage devices such as battery (single use or re-chargeable) or capacitors, energy harvesting methods (RF, vibrational, thermal, solar), etc. These sources may be finite and used for a period of time after the main circuit is de-energized (possibly recharging when power is returned or with manual intervention), or used for brief periods of time on-demand to provide momentary indication of status.
∘ Examples of continuous power may include a network power (such as Power-over-Ethernet (PoE) or similar with a backup uninterruptable power supply (UPS)), generator supplied, or a separate control power at a non-hazardous voltage that has an independent architecture from the main circuit (must be independent so that secondary power is available when main circuit is shut down, locked and tagged out).

**Device self-test/diagnostics.** When verifying the absence of a signal, such as voltage, it is important to verify the device or circuit used to test for voltage or make the voltage measurement is functioning as expected both prior to and after the point in the process when the absence of voltage is confirmed. The self-diagnostics is likely a series of checks and verifications that are conducted to ensure that the critical components, circuits, or processes are operational and performing as expected. This helps guarantee that an installed testing device utilizing this complete method will result in a fail-safe indication and possibly be tolerant to certain types of faults or conditions.

Depending on the techniques used to implement the method, the self-diagnostics required and utilized for this step may vary. For instance, it may be important to know that the electronics responsible for performing the test of making the measurement are not damaged as a result of any surges or unexpected conditions on the circuit being monitored. Alternatively, this step can help ensure that the functionality of the device was not adversely impacted by any undesirable factors that could be present in the environment where the device has been installed. Therefore, confirming the functionality of the device both before and after the actual voltage test or measurement is essential in adding confidence to and ensuring the validity of the result.

**Voltage detection range.** Voltage presence indicators typically illuminate in the presence of voltage above a threshold that is considered non-hazardous. This value is typically approximately 30-50V. However, when validating the absence of a signal, it is not enough to indicate non-hazardous voltage - the detection circuit must be capable of determining that the circuit is de-energized which is as close to 0V as possible based on the capability of the test instrument and surrounding environment. Additionally the voltage detection technique(s) used to determine the absence, and possibly presence, of voltage must function reliably over the entire range of voltages that the device may be exposed to in the installation, regardless of whether the voltage is considered hazardous or non-hazardous.

**Automated test procedure.** Incorporating a logic based control within the device ensures that all of the steps necessary to verify the absence of voltage are completed, in the proper sequence, every time, before a final status indication is given. This improves upon the portable test instrument method where personnel are on their honor to verify the functionality of the test instrument (typically a volt meter or digital multimeter) before and after measuring voltage. It also demonstrates an improvement over the voltage presence indicators by incorporating the necessary checks for device functionality and connectivity between an installed testing device and the part of the circuit to be tested. This process may be microprocessor or controller-based and could incorporate varying degrees of fault-tolerance and may also be designed so to ensure that any failures, should they occur, result in a safe state. The system must also have the capability of communicating the result of the test (for example via LED indication, digital display, output to another device or linked network element, etc.)

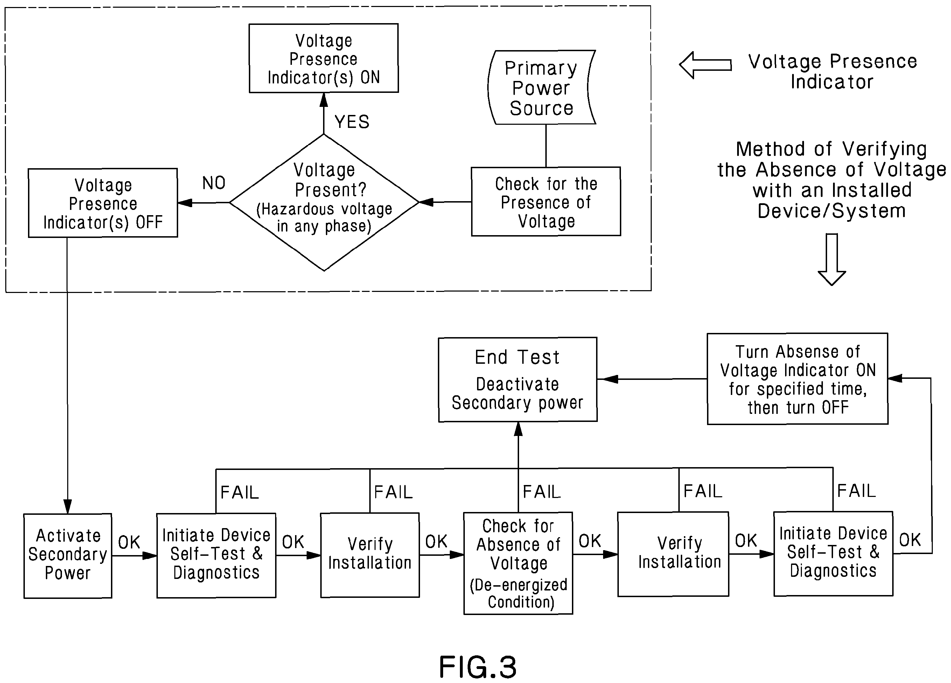

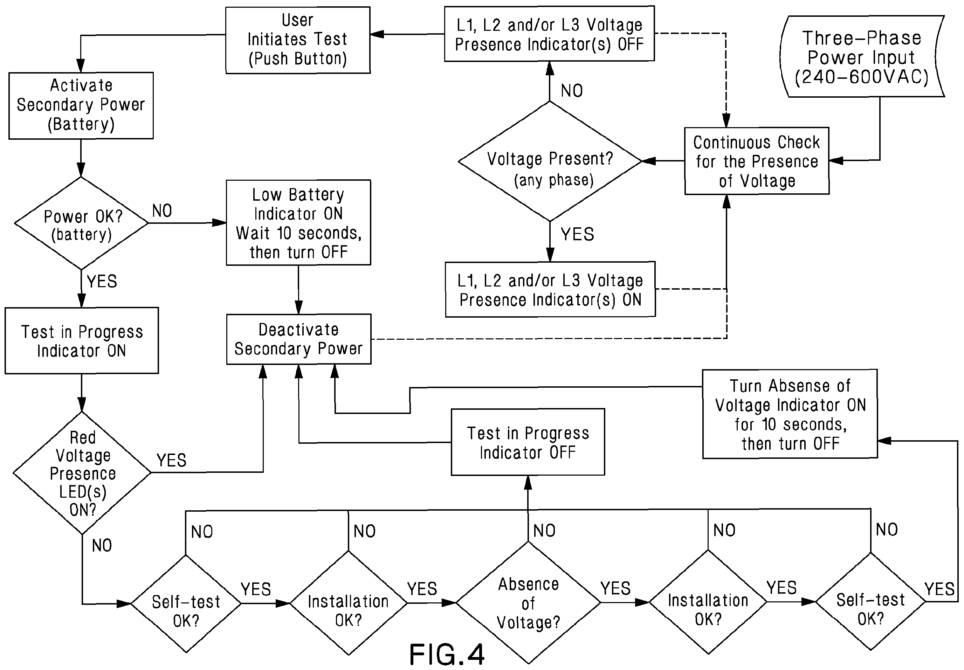

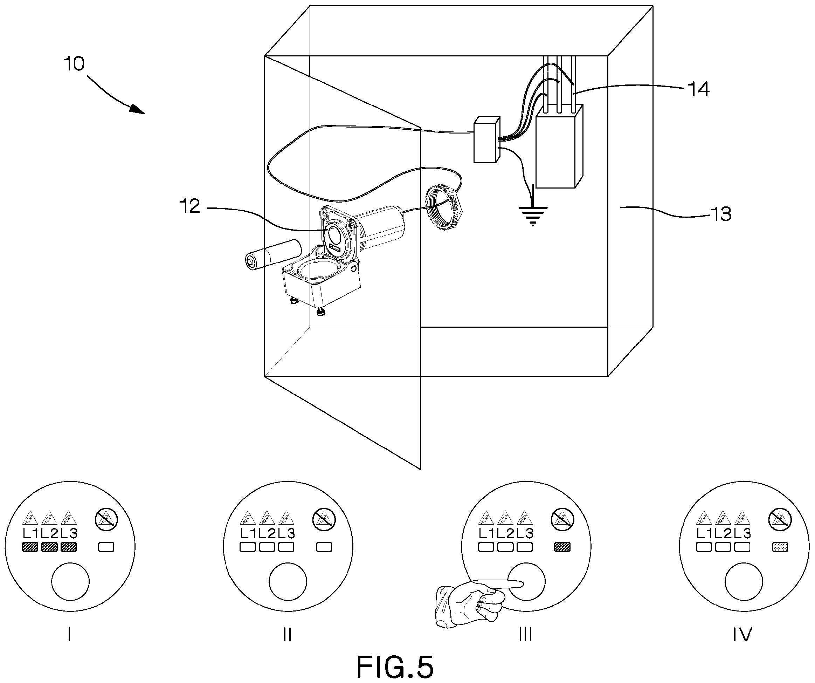

One example of this method using an installed testing device is shown in Figure 3. The method to verify the absence of a signal can be used independently or in conjunction with a voltage presence indication system. There are several possible variations on this method. For instance, it may be desirable to provide additional indications, such as "test in progress" once the secondary source has been activated, or the status of the secondary power. Another example shown in Figure 4 incorporates additional elements. Figure 5 illustrates a physical embodiment of a system with an installed testing device that utilizes the method in Figure 4, the system 10 includes an enclosure 13 with a door and a device 12, part of which is mounted on the door. The device 12 is electrically connected to a power source 14. In one embodiment, the device can show illuminated power LEDs (one for each phase) to show power is present (see panel I in Figure 5), no illumination (panel II) when there isn't, then upon depressing a test button, it can illuminate a test LED (panel III) and to show the test is in progress and confirmation LED (panel IV) if the test confirms an absence of voltage.

In one embodiment, a installed testing device can have increased functionality by monitoring the presence and absence of voltage on both the line (supply) and load side of an electrical disconnect, in addition to the status of the disconnect.

When separate installed testing devices are installed on both the line and load side, some increased functionality is available. For example, the line side device can be used to indicate the status of voltage within a panel or to visually provide indication of a phase loss. The load side device can be used to confirm the status of the electrical disconnect. If the disconnect experiences a mechanical failure or a circuit breaker contact becomes welded, the installed testing device can provide a visual indication. However, if the upstream disconnect is powered off prior to opening the disconnect being monitored on the line and load side (which could be the case during complex or cascading lockout/tagouts, or scheduled shutdowns), the status of the disconnect cannot be confirmed without checking for continuity across the line and load contacts of each phase. This is because if the upstream power is off, the status of the load device will show a lack of voltage regardless of the position of the disconnect.

To prevent this type of error, procedures can be put in place to dictate the order of these operations during complex lockout/tagouts. Additionally, during shutdowns qualified electrical workers will often use a voltmeter to check for voltage across the line side of the disconnect, the load side of the disconnect, and finally meter across each phase (line-to-load) to check for resistance. This is a good practice, however it can be time consuming and is only effective if each step of the process is followed and performed in sequence.

Additionally, installing two separate devices may be cost-prohibitive (both component cost and cost of installation should be considered) and there may be spatial constraints on the electrical enclosure.

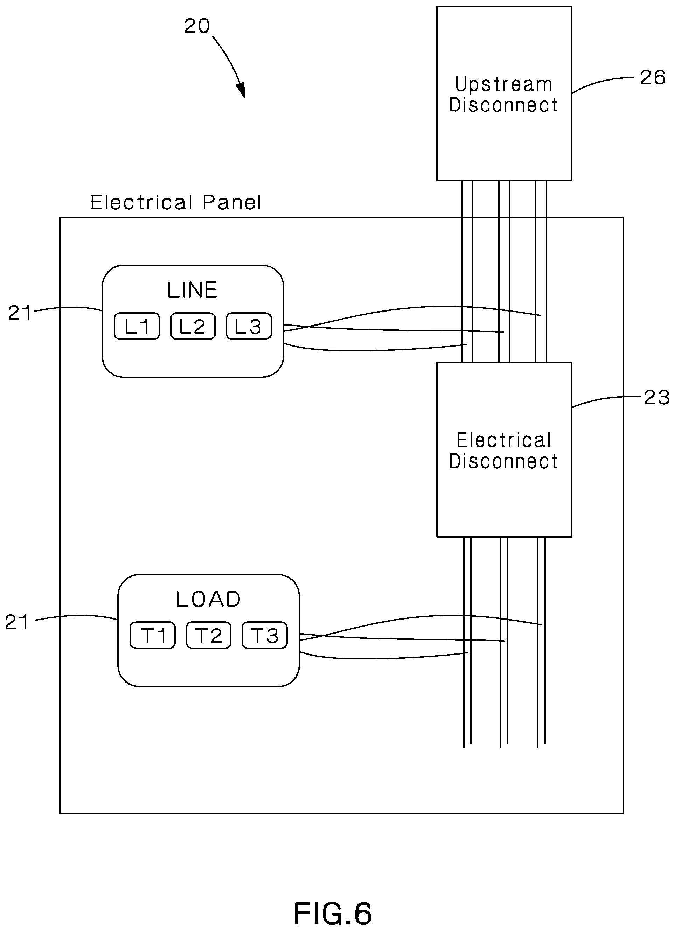

Figure 6 shows using separate monitors on both the line and supply side. Standard practice is to follow proper lockout tagout procedures to obtain accurate results when interpreting the indications. When using this method with individual line and load side indicators, it is important that the user first opens, locks, and tags the downstream disconnect first when isolating electrical energy. If the user starts with the upstream device, best practices would require the user to meter across the disconnect to verify that all contacts are fully open.

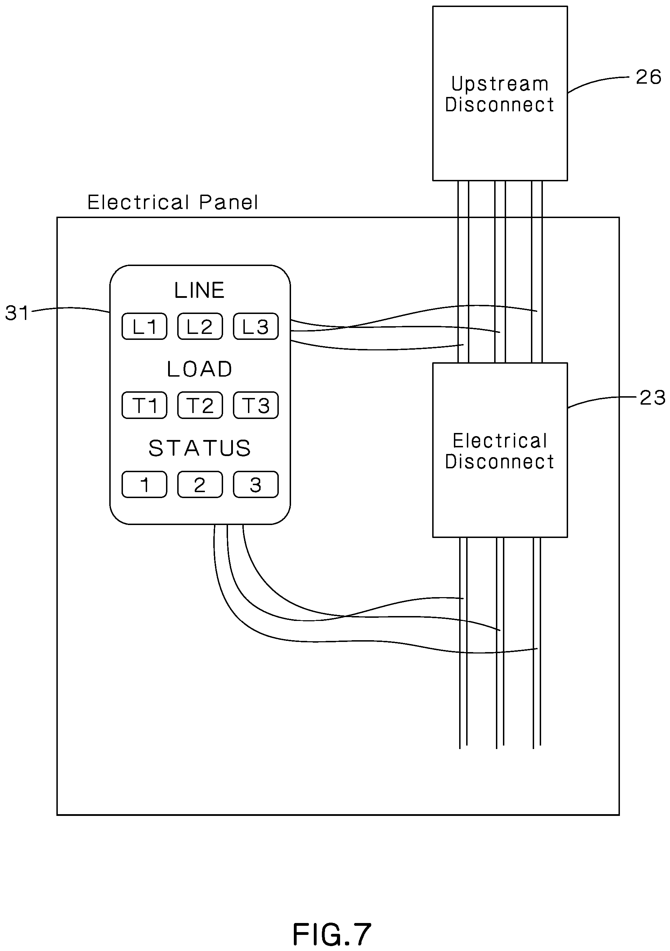

To increase functionality even more, a setup as shown in Fig. 7 is used with a process such as the one shown in 8 is used. A secondary power source or stored non-hazardous energy source (e.g., battery, network power, ultracap, etc.) is used to initiate self-diagnostics. If the device successfully meets the criteria established for the self-diagnostic tests, the installation is then verified by utilizing any variety of methods to establish continuity between the test device and the circuit that is being monitored. Once it has been established that the installation is satisfactory, a test for voltage is conducted on both the line and load sides. The voltage may be measured or a test for the presence above a certain threshold may be conducted. If the absence of voltage is verified, the next step is to verify that there is no continuity across the contacts (line and load) of each phase. This is a crucial step and ensures that the disconnect is in fact open and mechanical failure (such as a welded contact in a circuit breaker or a knife blade that is not fully disengaged) has not occurred.

This method allows the user to determine the status of voltage and the disconnect before opening the panel regardless of whether the equipment is operational, shutdown for maintenance, or if a breakdown has occurred in the LOTO process.

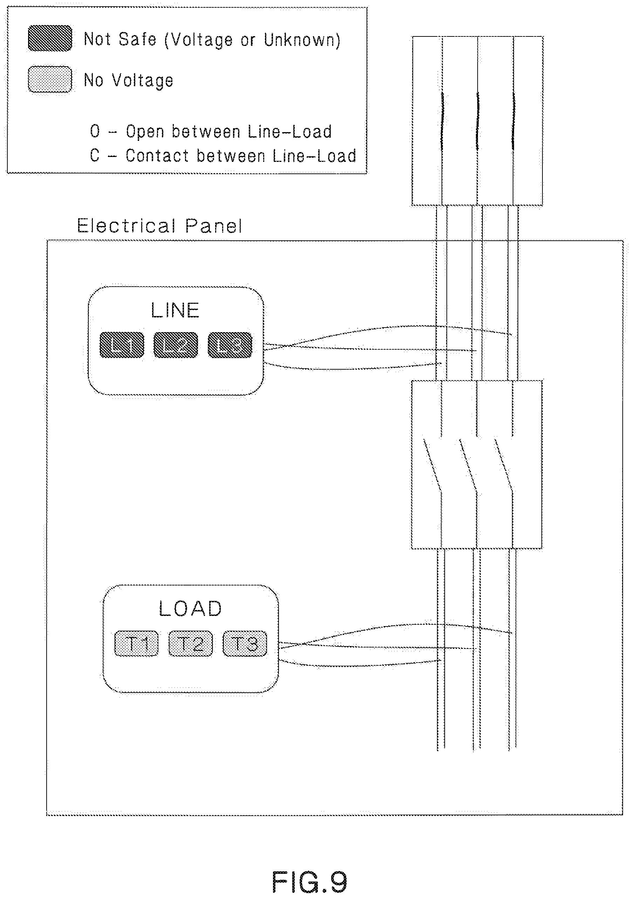

Figure 9 shows a system 20 with an upstream disconnect 24 closed (power on line side) and the disconnect in the enclosure 23 open with a testing device 21 on both the line and load side of the disconnect 23. Figure 10 shows another system 30 that has a single testing device 31 connected to both the line and the load side of the disconnect 23. Figures 11 and 12 show the same setup as Figures 9 and 10 but with the disconnect in panel open and a problem on phase 2. Figure 13 and 14 shows a system similar to Figures 11 and 12 with the upstream disconnect open and the disconnect in panel open with problem on phase 2.

In a further embodiment, this system can build upon the concept of a permanently installed testing device. Although the voltage indicator described above could be part of a system or network, it is also often embodied as a standalone device with supplemental power being provided by a battery for brief periods upon a prompt from the user. Basic operation of this device, to initiate a test for the absence of voltage when the device is in an unpowered state, is shown in Figure 15. Because this device will go through periods of having no power and is not connected to a network (standalone), the device does not have a method to establish a clock to establish when a test occurs. Similarly, because the device is independent of a network, the only way to record the resulting indication is manually by the user. This type of electronic device monitors a single point in a circuit and thus, it is likely that several unique devices would be installed within a facility. The further embodiment provides a method to view the intermediate steps, data, and status that are used to determine a final result or indication; a method to record the voltage test was completed and to automatically record the results, and a method to add a time and date stamp to the results from a test initiated on a standalone device without a network infrastructure (Figure 12).

To accomplish this, several elements are needed: test algorithm that writes results to memory, wireless transmission capability must exist within the device, a portable reader/display with wireless capability must be available, and corresponding software.
- The test algorithm must contain a step that includes writing the results (intermediate data and status and/or final indication) to memory. Each time the user initiates a new test, all of the results in memory must be cleared before any new results are overwritten to ensure that the data in memory is always from the same test. The addition of this step is transparent to the user as the user only sees the final indication on the device interface.
- One or more forms of wireless transmission must be incorporated into the device. By utilizing wireless techniques that do not rely on additional infrastructure, such as Bluetooth, beacons, RFID (radio frequency identification), or NFC (near field communication), deployment remains as simple as installing the standalone device.
- A portable reader/display ("reader") must be available. This is a portable apparatus (such as a smartphone, tablet, dedicated viewer, or other similar) with the ability to receive, and possible send, transmissions wirelessly from the standalone device. The reader must also have a display so that information about the testing device and test results can be visible to the user.
- To optimize viewing of the results, dedicated software or application (app) can be installed on the reader. The app can run locally on the device or it could be configured to sync with a server allowing results from multiple users and readers to be collated and archived. There may be additional software installed on the server or a cloud based platform to allow for management of devices online through web browser. Allow ability to download/export data collected from the standalone devices to other formats.

This method could be useful if applied to an installed testing device. For instance, if using NFC with the device, when the user initiates interaction with the unpowered device by depressing the "test" button, the voltage test sequence is initiated. As the microprocessor steps through the algorithm and other steps in the test sequence, data and results from the test sequence are written to the NFC tag(s). The device completes the test sequence and displays the result of the test sequence via the door-mounted indicator (Figure 19). The user can then use a device with NFC reading capability (a smartphone, tablet, or other similar device) to access an app, specially designed for use with the standalone voltage tester/indicator (Figure 20). Once the app is running, the user brings the phone in proximity to the testing device. The NFC reader then accesses data from the tag and displays it in the app. When data is displayed in the app, the results of the test are recorded, time stamped, and automatically logged. Within the app, the user has the ability to add notes or comments, flag unusual results for follow up action, or email results/status associated with a particular device (Figure 21). Additional software could be used to manage multiple standalone device, users, and/or portable readers.

Using this method to record and access additional data from a standalone device has several benefits and addresses several problems identified for standalone electronic devices without continuous power, specifically:
- The physical user interface on the device is kept simple. This method allows additional information to be accessed by the user without requiring a complicated interface or display, or larger physical embodiment.
- A single reader or (smaller group of readers) can be used to interact with multiple standalone devices. This has several benefits including minimized component costs (a single display is required for the reader, rather than a display for each standalone device), improved robustness and reliability (fewer components in the standalone device result in fewer connections and failure points; if the portable display fails, a new one can be obtained without any rework or maintenance to the standalone device installation)
- Additional information is accessible. Things like battery status can be indicated within the app. The voltage value or range of each phase could be displayed within the app (as opposed to an on/off indicator on the physical interface).
- The app can be used as a tool for troubleshooting. While the physical interface only displays a pass/fail result on the test, the app can be used to display results that are more granular. For instance, it could display results of each or selected steps in the test sequence allowing the user to distinguish if the test failed because voltage was present, the battery was low, or lead connection in the installation was not verified. It could also provide information on which phase(s) the error was recorded or report actual measured voltage values.
- The app can be used as a tool to time/date stamp each test and record test results. The device will always store the most recent test results in the memory. When data in the memory is read and transmitted from the device to the reader, it is imported into the app and that step can be time/date stamped which would otherwise not be possible with a standalone device that is not continuously powered.
   ∘ Useful to the end user (electrician can prove that test was performed), facility owner (have records and logs to audit and show insurance companies), and product manufacturer (results are recorded in case of an incident)
- View data from the right device, every time. In the case of the voltage indicator with NFC, the user is assured that the results and information viewed in the app are from the intended voltage tester/indicator device because of the proximity requirement of NFC technology. Similar functionality can be implemented with other wireless technologies - for instance, transmission signals can be dampened reducing the transmission distance resulting in proximity requirements for the standalone device and portable reader. Alternatively, other methods of feedback could be incorporated such as the reader transmitting a signal to activate an indicator on the standalone device.
- Self-contained, easy to use and deploy. There is no set-up, configuration, device pairing or IP addresses to manage. Additionally, the system operates without mobile or wireless access on the plant floor. A network connection is only required to optionally sync or archive data, if desired.
- Depending on the way this type of system is designed and implemented, there is a possibility that the portable reader could provide additional functionality by serving as a method to verify the functionality or to calibrate the standalone device.
- The app could be used as a way to view information about the installation and circuitry where the device is installed via a photo with date-stamp and information on when the installation was last modified. It may be useful for an electrical worker to see how the device was originally installed in the panel.

Similar functionality can be achieved with Bluetooth, beacons, Wi-Fi, or other wireless transmission methods. When using wireless signals that can transmit further than a few centimeters, an additional step can be added to ensure that when viewing result on the reader, the results being displayed are from a particular device, since there may be more than one in range of the reader. One or more of the following or similar methods could be incorporated into the device to verify results:
- Provide a feedback indicator on the standalone device when transmitting
- Mute the signal so that transmission distance is limited
- Incorporate an identification feature in the app to display a unique identifier (like a serial number or MAC address)
- Use a "button" in the app to trigger an indication light or signal on the standalone device for which results are being displayed

This method can allow the voltage indicator to be used in the following ways:
- Voltage tester/indicator as a standalone device
- Voltage tester/indicator as a device in a subsystem (e.g., as an input to an access control system)
- Voltage tester/indicator as a standalone device with local app
- Voltage tester/indicator as a device in a subsystems with local app
- Voltage tester/indicator as a standalone device with app connected to server
- Voltage tester/indicator as a device in a subsystem with app connected to a server

In an industrial environment, electrical equipment is often housed within a panel, cabinet, or other type of enclosure. Equipment ranging from power components (e.g., switches, circuit breakers, fuses, drives, contacts, etc.) to control and network products (e.g., PLCs, controllers, network switches, and power supplies, etc.) are often enclosed not only to provide protection from harsh or dynamic environments, but also to provide various levels of safety and security. Unauthorized access to an electrical, control, or network panel, whether intentional or unintentional, can lead to various hazards depending on the application especially if the electrical components are energized.

In recent years there has been an increased emphasis on electrical safety in the workplace with efforts to promote awareness of shock, arc flash, and arc blast hazards. When working on or near electrical equipment, hazards such as arc flash, arc blast, and electrical shock exist when voltage is present. OSHA enforces electrical safety via the general duty clause, relying heavily on content in voluntary consensus standards such as NFPA 70E, the Standard for Electrical Safety in the Workplace. With each revision of NFPA 70E, it is becoming less and less acceptable to perform tasks on energized equipment. In most cases, work involving electrical hazards is required to be performed in an electrically safe work condition (e.g., de-energized state). However, NFPA 70E also recognizes that some diagnostics and testing activities must be performed while the equipment is energized.

With industrial facilities become increasingly automated and networked, diagnostic activities have become more sophisticated. In many cases, startup configuration, troubleshooting, and testing of devices can be performed with only control/network power. It is generally accepted that lower voltages are less hazardous with regards to both electrical shock and arc flash. NFPA 70E Article 130(A)(3) specifically indicates that energized work on equipment rated less than 50V can be permitted. In industrial automation, control/network functions typically run at lower voltage levels (24Vdc). Thus, for many applications it is beneficial to have a separate infrastructure for control/network power within the panel that is not derived from the main power so that the main power source can be locked out while control/network power is available while certain tasks are performed.

Advances in technology have made personnel badging and access readers commonplace in many enterprise settings. Many industrial facilities also have measures in place to restrict and monitor access to various departments, laboratory, or production areas. These systems often run on network power or control voltage <50V. As power and control systems become intelligent with network capabilities, the lines between IT staff, electricians, and controls engineers are becoming blurred. With power, control, and network equipment all housed in similar enclosures, it is likely that someone who is unqualified to work on a particular type of equipment could try to access a panel creating hazards for him or herself, surrounding people, the equipment, or process - particularly in high pressure situations such as unplanned outages or situations where schedule delays must be avoided.

When an enclosure is outfitted with a testing device, enclosure lock, controller, and optional credential reader (all powered independently from the main power circuit) new methods to address the safety, security, and maintenance problems that occur in industrial facilities are possible. Often, these elements do not exist or if a subset is present in an enclosure, they function independently. The new concept described herein, presents an opportunity to solve some of these problems by presenting a new method to usher in the next generation of safety to security and maintenance practices.

Unauthorized access to an electrical, control, or network panel, whether intentional or unintentional, can lead to safety and security hazards that may affect people, equipment, or process. Using an access control system at the enclosure level that includes an electronic lock in conjunction with a credential reader users can control or restrict access to authorized people at authorized times. By powering the controller, lock, and credential reader via a non-hazardous source or energy storage device separate from the primary power (such as the network (PoE), battery, ultracap, etc.), voltage is limited to a safe level (50V or less) and the devices will continue to function as long as the secondary power is available, regardless of the status of the main/primary power sources within the enclosure. To further reduce risk, it may be desirable in some cases to further restrict access to situations only when the panel has been de-energized, or if special circumstances have been met (e.g., completion of an energized work permit.

As such, another embodiment includes a method that provides a novel way to mitigate the risk of exposure to electrical hazards, prevent process disruptions, and automate maintenance logs/records. As a result, increased levels of safety for personnel and equipment, reduced incidents, and trend identification, and possible liability or insurance incentives can be realized. Individually, the components that make up this system exist, however they are not leveraged collectively nor optimized for the functions described within this application.

This method, shown in its simplest form in 22 and 23, consists of a controller with input for a testing device and output to an electronic lock. The input and output contacts may be standard I/O, safety-rated and redundant, etc. or some combination. The testing device is configured to monitor the main power circuit within the enclosure. The testing device, lock, and controller are all powered from a non-hazardous voltage source independent of the main power circuit (this enables the devices in the system to operate even when the main power is isolated); the system components may be powered by the same source or separate sources (e.g., battery, network (PoE), etc.) The controller must have processing power to step through the logic outlined. The user requests access to the locked enclosure by testing for voltage. If voltage is present, the enclosure remains locked. If the absence of voltage has been verified, the controller will disengage the lock for a pre-determined amount of time (for instance, 10 seconds) allowing the user to open the door before the controller re-engages the lock. When the door is closed the process can be repeated again.

Figure 22 shows a basic process for using status of an installed testing device to control access to an enclosure. Figure 23 shows components and input/output relationship of a system with credential authentication.

Another variation is to include a form of credential authentication in the process to add additional security and prevent unauthorized personnel from accessing equipment. This is shown in 24 and 25. This method is similar to the basic process in Figure 22, but includes an extra step to verify the identity of the user (most likely prior to checking for voltage, although the sequence could be interchangeable). This additional functionality requires the controller to have two additional inputs for a credential reader (hardware installed on the exterior of the enclosure) and credential verification system. The credential verification system will typically consist of a database of credentials approved for access, external to the system linked via network from another system to the controller. However, in some cases this could be maintained within the controller. Regardless, in this embodiment, in addition to processing ability, the controller must also contain memory to store the credentials if operating as a standalone device or should the network connection be lost. The credential reader must be powered in the same manner as the controller, testing device, and lock.

In this embodiment, the user requests access to the system by presenting his or her credentials (something that you have - badge; something that you know - PIN or password; or something that you are - biometrics) to a credential reader. The credential reader is used to authenticate the identity of the user. If the credential presented to the reader is verified by the controller as valid based on the most-recent status from the credential verification system, a test for the absence of voltage is then conducted. If voltage is not present, the lock is opened and the user is granted access. However, if the credentials are not validated or the presence of voltage is detected or undeterminable, access is denied and the lock remains engaged.

It is possible to expand upon this concept in a more complex embodiment with advanced features, as shown in Figures 26A, 26B, and 27. Depending on the desired functionality, the embodiment may consist of all or a subset of these features.

The process begins by a user requesting access to an electrical panel with the elements shown in Figure 27 installed. The user may be requesting access based on a workorder he or she received generated in an enterprise asset management system. The workorder system may be linked as an input to the controller or it may be operating independently. By integrating the workorder system, it is possible to add checks to the process to ensure that the correct equipment is being accessed and the work can be scheduled in a timeframe that is least disruptive to other processes. Verifying that the correct equipment is being accessed will help increase safety as many industrial enclosures look similar and every year incidents occur when someone accesses the wrong equipment due to improper labeling or "look-alike" features. Further, damage to surrounding equipment or process can occur if the equipment being serviced is not first shut-down properly. Particularly in process industries, this can be hazardous to people, the environment, and surroundings. Thus, being able to set a timeframe for approved access is desirable. This feature can also be used to limit access to a particular area or piece of equipment for service technicians or contractors.

Once it has been determined that the equipment attempted to be serviced was approved for access, the next step is to verify the user's credentials. The user presents his or her credentials to the reader. This process may include scanning a badge or fob, entering a PIN or password on a keypad, or presenting a fingerprint, among other methods. The systems completes the process to authenticate the credentials by validating them via the credential verification system whether it is internal to the controller or linked via a separate system. This system may be linked to an active directory with a network connection to a server where credentials are stored. The credential may be further enhanced by including additional characteristics such as making sure the employee is authorized to access a particular type of equipment (for example, distinctions can be made by job role (maintenance versus office worker), or between people authorized to access high and low voltage equipment, different types of equipment such as control and automation equipment versus power distribution, equipment from a specific manufacturer, equipment in a particular zone or work cell, etc.) and cross-referencing a training database to ensure credentials are up-to-date. By integrating the credentials with training records, access can be contingent on ensuring that required classes or skill audits have been completed and documented within the system. This also sets the foundation to deliver specific need-based training on demand. For instance, prior to accessing a motor control center the user who requested access may be required to watch a brief safety video unique to a particular model of equipment or review a safety procedure.

Once credentials are validated, the controller can seek status from the voltage detector .If the voltage test determines that the equipment is de-energized, the lock can be disengaged granting the user access. However, if the panel is energized access can be denied or an additional set-of requirements can be incorporated into the controller logic to determine if access can be granted. For instance, energized work may be dependent on having additional documentation (approved energized work permit, completed job briefing, etc.) in the workorder or other linked system. Additionally, for some tasks, procedures may require more than one person to be present. The access system could be configured to require credentials from more than one user to be presented and authenticated prior to performing energized work or performing any work in a restricted area.

If all conditions have been determined satisfactory for the lock to disengage, access is granted to the enclosure. Depending on the style of lock used, the lock could engage automatically after a pre-determined period of time or it may be dependent on the position of the door. If a door position sensor is used, the controller could incorporate additional logic to determine when to send an alert or notification if the door has been open too long, if it is unexpectedly open, if it remains open when the panel is re-energized, etc. This further enhances safety and security of the overall system.

In addition to the usage already explained, another reason to implement such a system is to log and record access for energized and/or de-energized work. After access is granted or approved, the request and resulting process analysis and result can be logged. These results can then be sent as an alert or alarm if a communication mechanism is available or they could be displayed on a physical interface, for instance an HMI, mobile device, etc. Notifications of both access grants and denies are important and can be used to alert other affected personnel if work is being performed. For example, if access to energized work is approved, an alert could be sent to HMIs nearby within the arc flash boundary. Similarly, before a maintenance worker attempts to access a piece of equipment, he or she may be interested in viewing the previous access attempts and when they occurred (similar to how alarms are displayed on HMIs). The user could request to review these results via the panel HMI (or other similar visual interface); if access attempts are recent or align with when a problem began, the worker may want to get more information before beginning his work and attempting to open the panel.

Figure 28 shows another example of a system 60 for controlling access to an enclosure. The system 60 includes a badge reader 61, door sensor 62, enclosure lock 63, controller 64, testing device 65, power source to be monitored 66, network connection 67, and an interface 68.

The processes described herein represent three embodiments ranging from basic to advanced; one skilled in the art will recognize that there are other variations in sequence that may be just as effective or desirable based on the combination of features and functionality implemented. For example, the system could be configured to only require credentials if the system is energized in which case the voltage test would occur before the credential verification step.

The required hardware will depend on the amount of functionality desired and implemented. In the basic embodiment, the logic could be embedded in a stand-alone controller. As additional functionality is added, a networked option and/or software to provide easier management of credentials and conditions may provide a useful interface.

When this method is implemented, the following benefits listed below are provided.

Mitigation of electrical hazards. Anytime equipment is energized, electrical shock and arc flash hazards exist; however, voltages less than 50V AC or 60V DC are generally considered safe. Utilizing a safe powered access control or enclosure "lock" could prove beneficial in the following scenarios:
- Preventing unqualified personnel from accessing an energized electrical panel, exposing hazards
- Preventing qualified personnel from opening an energized electrical panel without proper authorization, such as an energized work permit
- Preventing access to a compartment with more than one voltage source when all voltage sources are not de-energized
- Preventing access to compartments/panels until stored energy has been dissipated to a safe level
- Preventing access to an incorrect compartment or enclosure ( look-a-like equipment)
- Providing verification that the enclosure door or cover has been properly closed before commissioning or re-energizing equipment
- Ensuring doors and covers are properly closed and latched on arc resistant equipment
- Ensuring that qualified individuals, with proper training and access levels, are present for certain tasks (some safety procedures require two people to be present)
- Ensuring that individuals have completed all necessary training and training records are up-to-date before access is allowed to a compartment.

Prevention of process disruptions. In applications where each minute of downtime comes with a price tag of thousands of dollars, minimizing process disruptions is essential. Additionally, certain processes may be hazardous if not properly controlled, thus limiting access to control functions and settings can have major security and safety implications. The access control or enclosure "lock" is also applicable in the following scenarios:
- Prevent access and/or provide a record of what equipment was accessed by individuals
- Prevent unauthorized personnel from accessing equipment and provide a record of personnel who have accessed specific equipment
- Prevent access at certain times and provide a record of when equipment was accessed
- Prevent the altering of settings or parameters on the incorrect equipment, controller, or endpoint device
   ∘ Avoid errors with look-a-like equipment, providing easy identification
   ∘ Avoid changes that may be disruptive to a process at a particular time in the cycle

Next-generation maintenance & record keeping. Monitoring and controlling access at the panel or compartment level in industrial environments has the potential to revolutionize maintenance and record keeping, especially when combined with voltage testing. As companies are facing stricter documentation requirements in regulations and codes, there is a need for product and tools that simplify compliance. The following scenarios describe how an access control or enclosure "lock" can help improve basic maintenance tasks.
- Advance maintenance practices by taking an "electronic charting" approach to industrial equipment, similar to the transition from paper to digital records in the medical and dental recordkeeping
- Ensure that personnel has the proper credentials, or role to access the equipment
- Ensure that the individual has up-to-date training on specific types of equipment
- Make access contingent to review of a schematic, work order, completion of a training model, procedure review, or checklist verification. May require link to a HMI, tablet, etc. and a database with barcodes or other means of identification on equipment and/or components.
- Create a "log file" to display history of access requests and corresponding results on HMI, mobile device, etc.

Additionally, the ability to lock out the primary power source and still access control functions could have the following benefits:
- Reduction in PPE: particularly beneficial for when PPE may limit dexterity and can create additional hazards, especially in harsh environments (extreme hot/cold, wet weather, etc.).
- No need for an energized work permit: in many companies this often requires executive approval and can be a lengthy process. Using the voltage detector as an input to the access system can help prevent workers from being exposed to energized parts
- Increased levels of safety for personnel and equipment
- Reduced incidents (avoid downtime, losses due to injury, minimize equipment replacement)
- Coupling this product with an automated documentation system can help reduce liability, by
   ∘ Proactively identifying training gaps
   ∘ Keeping maintenance records and provide warnings when tasks are due
   ∘ Providing a method to integrate maintenance and safety records
   ∘ Reducing errors from manual data entry
- Identify patterns and trends for certain equipment, personnel, or events
- Insurance incentives or reduced premiums for companies or locations

Adding intelligence, via the network capability, to voltage detection and indication systems enables additional information such as status of components related to safety to be available in real time. By adding network capability (or output contacts) to the voltage detector additional display and information activities are now possible. For instance, if switching is performed remotely, the output from the voltage detector could also be displayed via a HMI in remote locations. Additionally, if using a continuous power source (such as PoE), rather than an intermittent source, a positive indication for both the absence and presence of voltage will be displayed as long as power is available. Network capability also allows to supplement the physical interface with a more intricate display, for example indicating when voltage was last detected or more information on any other status changes.

Another embodiment could include an override code or key to allow access to the energized panel in special situations that may be required for certain applications or by qualified personnel if allowed by safety policy.

While particular embodiments and applications of the present invention have been illustrated and described, it is to be understood that the invention is not limited to the precise construction and compositions disclosed herein and that various modifications, changes, and variations may be apparent from the foregoing without departing from the scope of the invention as described.

## Claims

1. An installed device (21, 31) for detecting the absence of voltage in a monitored circuit located within an electrical enclosure (23), the monitored circuit being powered by a primary power source (14), the installed device comprising:
a housing; and
circuitry electrically connecting the installed device to the monitored circuit and a secondary power source, the secondary power source being independent of the primary power source;
the circuitry being configured to:
check for the presence of voltage in the monitored circuit;
perform, upon a lack of detecting voltage in the monitored circuit or initiation by a user, a self diagnostic using the secondary power source to confirm proper operability of the installed device;
test, upon confirming proper operability of the installed device, for connectivity to the monitored circuit;
detect, upon confirming connectivity to the monitored circuit, for a de-energized condition of the monitored circuit, the de-energized condition being a substantially zero voltage;
re-test, upon detecting the de-energized condition of the monitored circuit, for connectivity to the monitored circuit;
re-perform, upon confirming connectivity to the monitored circuit, a self-diagnostic to ensure proper operability of the installed device; and
confirm, upon confirming proper operability of the installed device, the de-energized condition of the monitored circuit.

2. The device (21, 31) of claim 1 wherein the circuitry is also configured to display a positive indication of a lack of voltage in the monitored circuit.

3. The device (21, 31) of claim 1 wherein the circuitry is connected to both a line and a load side of an electrical disconnect (23).

4. The device (21, 31) of claim 3 wherein the circuitry is also configured to check a status of the disconnect (23).

5. The device (21, 31) of claim 1 wherein the circuitry is further configured to interact with a portable reader in order to transfer information from the device to the portable reader.

6. The device (21, 31) of claim 1 wherein the circuitry is further configured to communicate with a controller that is used to control access to a panel.

7. A method for testing for the absence of voltage in a monitored circuit located within an electrical enclosure (23), the method using an installed device (21, 31) electrically connected to the monitored circuit, the monitored circuit being powered by a primary power source (14), the method comprising having the installed device perform the steps of :
checking for the presence of voltage in the monitored circuit;
performing, upon a lack of detecting voltage in the monitored circuit or initiation by a user, a self diagnostic using a secondary power source that is independent of the primary power source, to confirm proper operability of the installed device;
testing, upon confirming proper operability of the installed device, for connectivity to the monitored circuit;
detecting, upon confirming connectivity to monitored circuit, for a de-energized condition of the monitored circuit, the de-energized condition being a substantially zero voltage;
re-testing, upon detecting the de-energized condition of the monitored circuit, for connectivity to the monitored circuit;
re-performing, upon confirming connectivity to the monitored circuit, a self-diagnostic to ensure proper operability of the installed device; and
confirming, upon confirming proper operability of the installed device, the de-energized condition of the monitored circuit.

8. The method of claim 7 further comprising providing that the device be electrically connected to the line and load side of a disconnect (23) and having the device check a status of the disconnect.

9. The method of claim 7 further comprising providing a portable reader and having the device transfer information to the portable reader.

10. The method of claim 7 further comprising electrically connecting the device to a controller wherein the controller controls access to a panel.

## Patentansprüche

1. Installierte Vorrichtung (21, 31) zum Detektieren des Nichtvorhandenseins von Spannung in einer überwachten Schaltung, die innerhalb einer elektrischen Umhausung (23) angeordnet ist, wobei die überwachte Schaltung durch eine primäre Stromquelle (14) gespeist wird, wobei die installierte Vorrichtung Folgendes umfasst:
ein Gehäuse; und
eine Schaltungsanordnung, die das installierte Vorrichtung elektrisch mit der überwachten Schaltung und einer sekundären Stromquelle verbindet, wobei die sekundäre Stromquelle unabhängig von der primären Stromquelle ist;
wobei die Schaltungsanordnung zu Folgendem ausgelegt ist:
Prüfen, ob Spannung in der überwachten Schaltung vorhanden ist;
Durchführen, wenn keine Spannung in der überwachten Schaltung detektiert wird oder bei Initiierung durch einen Benutzer, einer Selbstdiagnose unter Verwendung der sekundären Stromquelle, um die ordnungsgemäße Betriebsfähigkeit der installierten Vorrichtung zu bestätigen;
Testen, nach Bestätigung der ordnungsgemäßen Betriebsfähigkeit der installierten Vorrichtung, auf Konnektivität mit der überwachten Schaltung;
Detektieren, nach Bestätigung der Konnektivität mit der überwachten Schaltung, auf einen nicht-gespeisten Zustand der überwachten Schaltung, wobei es sich bei dem nicht-gespeisten Zustand um eine Spannung von im Wesentlichen null handelt;
erneutes Testen, nach Detektion des nicht-gespeisten Zustands der überwachten Schaltung, auf Konnektivität mit der überwachten Schaltung;
erneutes Durchführen, nach Bestätigung der Konnektivität mit der überwachten Schaltung, einer Selbstdiagnose, um die ordnungsgemäße Betriebsfähigkeit der installierten Vorrichtung sicherzustellen; und
Bestätigen, nach Bestätigung der ordnungsgemäßen Betriebsfähigkeit der installierten Vorrichtung, des nicht-gespeisten Zustands der überwachten Schaltung.

2. Vorrichtung (21, 31) nach Anspruch 1, wobei die Schaltungsanordnung außerdem dazu ausgelegt ist, eine positive Angabe des Fehlens von Spannung in der überwachten Schaltung anzuzeigen.

3. Vorrichtung (21, 31) nach Anspruch 1, wobei die Schaltungsanordnung sowohl mit einer Leitungs- als auch einer Lastseite eines elektrischen Trennelements (23) verbunden ist.

4. Vorrichtung (21, 31) nach Anspruch 3, wobei die Schaltungsanordnung außerdem dazu ausgelegt ist, einen Status des Trennelements (23) zu prüfen.

5. Vorrichtung (21, 31) nach Anspruch 1, wobei die Schaltungsanordnung ferner dazu ausgelegt ist, mit einem tragbaren Lesegerät zu interagieren, um Informationen von der Vorrichtung an das tragbare Lesegerät zu übertragen.

6. Vorrichtung (21, 31) nach Anspruch 1, wobei die Schaltungsanordnung ferner dazu ausgelegt ist, mit einer Steuerung zu kommunizieren, die zum Steuern des Zugriffs auf ein Panel verwendet wird.

7. Verfahren zum Testen auf Nichtvorhandensein von Spannung in einer überwachten Schaltung, die innerhalb einer elektrischen Umhausung (23) angeordnet ist, wobei das Verfahren eine installierte Vorrichtung (21, 31) verwendet, das elektrisch mit der überwachten Schaltung verbunden ist, wobei die überwachte Schaltung durch eine primäre Stromquelle (14) gespeist wird, wobei das Verfahren umfasst, dass das installierte Vorrichtung die folgenden Schritte durchführt:
Prüfen, ob Spannung in der überwachten Schaltung vorhanden ist;
Durchführen, wenn keine Spannung in der überwachten Schaltung detektiert wird oder bei Initiierung durch einen Benutzer, einer Selbstdiagnose unter Verwendung einer sekundären Stromquelle, die von der primären Stromquelle unabhängig ist, um die ordnungsgemäße Betriebsfähigkeit der installierten Vorrichtung zu bestätigen;
Testen, nach Bestätigung der ordnungsgemäßen Betriebsfähigkeit der installierten Vorrichtung, auf Konnektivität mit der überwachten Schaltung;
Detektieren, nach Bestätigung der Konnektivität mit der überwachten Schaltung, auf einen nicht-gespeisten Zustand der überwachten Schaltung, wobei es sich bei dem nicht-gespeisten Zustand um eine Spannung von im Wesentlichen null handelt;
erneutes Testen, nach Detektion des nicht-gespeisten Zustands der überwachten Schaltung, auf Konnektivität mit der überwachten Schaltung;
erneutes Durchführen, nach Bestätigung der Konnektivität mit der überwachten Schaltung, einer Selbstdiagnose, um die ordnungsgemäße Betriebsfähigkeit der installierten Vorrichtung sicherzustellen; und
Bestätigen, nach Bestätigung der ordnungsgemäßen Betriebsfähigkeit der installierten Vorrichtung, des nicht-gespeisten Zustands der überwachten Schaltung.

8. Verfahren nach Anspruch 7, das ferner umfasst, dass dafür gesorgt wird, dass die Vorrichtung elektrisch mit der Leitungs- und Lastseite eines Trennelements (23) verbunden ist, und veranlassen, dass die Vorrichtung einen Status des Trennelements prüft.

9. Verfahren nach Anspruch 7, ferner umfassend Bereitstellen eines tragbaren Lesegeräts und Veranlassen, dass die Vorrichtung Informationen an das tragbare Lesegerät überträgt.

10. Verfahren nach Anspruch 7, ferner umfassend elektrisches Verbinden der Vorrichtung mit einer Steuerung, wobei die Steuerung den Zugriff auf ein Panel steuert.

## Revendications

1. Dispositif installé (21, 31) pour détecter l'absence de tension dans un circuit surveillé situé dans une enceinte électrique (23), le circuit surveillé étant alimenté par une source de puissance primaire (14), le dispositif installé comprenant :
un boîtier ; et
des circuits connectant électriquement le dispositif installé au circuit surveillé et une source de puissance secondaire, la source de puissance secondaire étant indépendante de la source de puissance primaire ;
les circuits étant configurés pour :
vérifier la présence de tension dans le circuit surveillé ;
réaliser, lors d'un manque de détection de tension dans le circuit surveillé ou du démarrage par un utilisateur, d'un auto-diagnostic en utilisant la source de puissance secondaire pour confirmer un bon fonctionnement du dispositif installé ;
tester, lors de la confirmation de bon fonctionnement du dispositif installé, une connectivité au circuit surveillé ;
détecter, lors de la confirmation de connectivité au circuit surveillé, une condition désactivée du circuit surveillé, la condition désactivée étant une tension sensiblement nulle ;
tester à nouveau, lors de la détection de la condition désactivée du circuit surveillé, la connectivité au circuit surveillé ;
réaliser à nouveau, lors de la confirmation de la connectivité au circuit surveillé, un auto-diagnostic pour s'assurer du bon fonctionnement du dispositif installé ; et
confirmer, lors de la confirmation de bon fonctionnement du dispositif installé, la condition désactivée du circuit surveillé.

2. Dispositif (21, 31) selon la revendication 1, les circuits étant également configurés pour afficher une indication positive d'un manque de tension dans le circuit surveillé.

3. Dispositif (21, 31) selon la revendication 1, les circuits étant connectés à la fois à une ligne et à un côté charge d'une déconnexion (23) électrique.

4. Dispositif (21, 31) selon la revendication 3, les circuits étant également configurés pour vérifier un état de la déconnexion (23).

5. Dispositif (21, 31) selon la revendication 1, les circuits étant en outre configurés pour interagir avec un lecteur portable afin de transférer des informations du dispositif au lecteur portable.

6. Dispositif (21, 31) selon la revendication 1, les circuits étant en outre configurés pour communiquer avec un contrôleur utilisé pour commander un accès à un panneau.

7. Procédé de test de l'absence de tension dans un circuit surveillé situé dans une enceinte électrique (23), le procédé utilisant un dispositif installé (21, 31) connecté électriquement au circuit surveillé, le circuit surveillé étant alimenté par une source de puissance primaire (14), le procédé comprenant la réalisation par le dispositif installé des étapes suivantes :
vérification de la présence de tension dans le circuit surveillé ;
réalisation, lors d'un manque de détection de tension dans le circuit surveillé ou du démarrage par un utilisateur, d'un auto-diagnostic en utilisant une source de puissance secondaire indépendante de la source de puissance primaire, pour confirmer un bon fonctionnement du dispositif installé ;
test, lors de la confirmation de bon fonctionnement du dispositif installé, d'une connectivité au circuit surveillé ;
détection, lors de la confirmation de connectivité au circuit surveillé, d'une condition désactivée du circuit surveillé, la condition désactivée étant une tension sensiblement nulle ;
test à nouveau, lors de la détection de la condition désactivée du circuit surveillé, de la connectivité au circuit surveillé ;
réalisation à nouveau, lors de la confirmation de la connectivité au circuit surveillé, d'un auto-diagnostic pour s'assurer du bon fonctionnement du dispositif installé ; et
confirmation, lors de la confirmation de bon fonctionnement du dispositif installé, de la condition désactivée du circuit surveillé.

8. Procédé selon la revendication 7, comprenant en outre le fait d'assurer que le dispositif est connecté électriquement à la ligne et au côté charge d'une déconnexion (23) et la vérification par le dispositif d'un état de la déconnexion.

9. Procédé selon la revendication 7, comprenant en outre la fourniture d'un lecteur portable et le transfert par le dispositif d'informations au lecteur portable.

10. Procédé selon la revendication 7, comprenant en outre la connexion électrique du dispositif à un contrôleur, le contrôleur commandant un accès à un panneau.
